(19) **Europäisches Patentamt**

**European Patent Office**

**Office européen des brevets**

(11) Veröffentlichungsnummer: **0 142 692**
**B1**

(12) **EUROPÄISCHE PATENTSCHRIFT**

(45) Veröffentlichungstag der Patentschrift:
**22.06.88**

(21) Anmeldenummer: **84112085.0**

(22) Anmeldetag: **09.10.84**

(51) Int. Cl.⁴: **H 01 L 21/58, G 01 L 9/00**

(54) **Montage von Halbleiterbauteilen auf einer Trägerplatte.**

(30) Priorität: **12.10.83 DE 3337173**

(43) Veröffentlichungstag der Anmeldung:
**29.05.85 Patentblatt 85/22**

(45) Bekanntmachung des Hinweises auf die Patenterteilung:
**22.06.88 Patentblatt 88/25**

(84) Benannte Vertragsstaaten:
**DE FR GB IT**

(56) Entgegenhaltungen:
**FR - A - 1 502 347**
**US - A - 4 019 388**
**US - A - 4 025 942**
**US - A - 4 399 707**

**REVIEW OF THE ELECTRIC COMMUNICATION
LABORATORIES, Band 27, Nr. 1/2, Januar/Februar 1979,
Seiten 92-96, Tokyo, JP; I. NISHI et al.: "Full wafer size
LSI mounting"**

(73) Patentinhaber: **Siemens Aktiengesellschaft Berlin und
München, Wittelsbacherplatz 2, D-8000 München 2 (DE)**

(72) Erfinder: **Hagen, Heinz, Ing. grad.,
Albrecht-Dürer-Strasse 32, D-8014 Neubiberg (DE)**
Erfinder: **Friedl, Helmut, Karl-Valentin-Strasse 28,
D-8022 Grünwald (DE)**
Erfinder: **Wintzer, Manfred, Karl-Marx-Ring 58,
D-8000 München 83 (DE)**

## Beschreibung

Die Erfindung betrifft die Montage von Halbleiterbauteilen auf einer Trägerplatte, insbesondere von Druckmesswandlern mit einer piezoresistiven Halbleitermembran auf einer die Halbleitermembran mechanisch stabilsierenden Trägerscheibe.

Drucksensoren in piezoresistiver Halbleiterbauweise sind ausführlich zum Beispiel in der Patentschrift DE 2 541 944 beschrieben. Beim Einbau derartiger Sensoren in Metall- oder Kunststoffgehäuse oder in Rohrleitungen muss besonders darauf geachtet werden, dass keine mechanischen Spannungen auf die teilweise sehr dünnen Membranen übertragen werden und hier durch Deformieren der Membran Drucksignale vortäuschen oder dass sich bei den üblichen Betriebstemperaturschwankungen aufgrund unterschiedlicher Wärmeausdehnungen der verwendeten Werkstoffe keine Ausdehnungsspannungen mit den gleichen Folgen ausbilden können. Ausserdem wird eine möglichst starre Verbindung des Sensors zum Gehäuse gefordert, da elastische oder dehnbare Verbindungen, zu denen vorwiegend die Klebverbindungen zählen, zu Messwerten mit Hystereseausbildung führen. Ferner wird angestrebt, die Werkstoffauswahl für den unmittelbaren Sensorträger durch das Einbau- oder Verbindungsverfahren möglichst nicht einzuschränken, um je nach Sensortyp zwischen isolierenden, elektrisch leitenden oder chemisch resistenten Werkstoffen wechseln zu können.

In den US-PS 3 918 019 sowie 3 397 278 und den DE-OS 2 938 240 und 2 913 772 werden Verfahren zum starren Verbinden eines Silizium-Drucksensors mit Glasunterlagen beschrieben. Nachteile dieses Anodischen-Verbindungsverfahrens sind, dass eine Temperatur von mindestens 250 °C und eine Gleichspannung von mindestens 500 Volt benötigt werden und dieses Verfahren nur die Verbindung des Silizium-Halbleiters mit einigen anderen elektrisch isolierenden Werstoffen erlaubt (zum Beispiel kein Quarzglas oder Halbleitermaterialien). Selbst bei guter Übereinstimmung der Ausdehnungskoeffizienten der beiden ausgewählten Werkstoffe (Silizium und Glas) wirken sich bei den erforderlichen hohen Verbindungstemperaturen die tatsächlich noch vorhandenen Ausdehnungsunterschiede sehr nachteilig auf die Messwerte des Sensors aus.

In der DE-OS 2 926 154 wird eine andere Verbindungstechnik beschrieben. Hier wird der Siliziumsensor mit einer zuvor durch Metallabscheidung metallisierten Keramik durch Goldlötung verbunden. Das Gold haftet am Silizium über eine sich beim Löten bildende Au-Si-Eutektikum-Legierungsschicht. Der Nachteil dieses Verfahrens sowie aller übrigen mittels eines Silizium-Metall-Eutektikum-Legierverfahrens erzielten Verbindungen (zum Beispiel Silizium-Zinn oder Silizium-Aluminium) liegt in den erforderlich hohen Metallschmelz- bzw. Legiertemperaturen.

Der Erfindung liegt die Aufgabe zugrunde, die erwähnten Nachteile der Anodischen- und Legierverbindungen zu beseitigen und das Problem der mechanisch spannungsfreien Montage von Halbleiterbauelementen auf einer Trägerplatte, insbesondere von Druckmesswandlern mit einer piezoresistiven Halbleitermembran auf einer, die Halbleitermembran mechanisch stabilisierenden Trägerscheibe, zu lösen. Damit soll auch die Verfälschung der Messwerte durch Hysterese und Temperaturveränderungen reduziert werden. Ausserdem soll es möglich sein, für isolierte oder nicht isolierte Aufbauten unterschiedliche Trägermaterialien (Glas, Silizium, andere Halbleiterwerkstoffe oder Metalle) zu verwenden.

Für die Lösung dieser Aufgabe werden die im Kennzeichen der Patentansprüche enthaltenen Massnahmen vorgeschlagen.

Die Erfindung beruht auf der Erkenntnis, dass sehr saubere Goldschichten, deren Oberflächenkräfte noch nicht durch Gase oder Feuchtigkeit abgesättigt sind, bei innigem Kontakt miteinander bei Raumtemperatur und nahezu ohne äussere Druckeinwirkung unlösbar «verschweissen». Die wirksam werdenden Verbindungskräfte sind als «Kohäsionskräfte» bekannt. Nach einer Weiterbildung der Erfindung wird mit einer Haftschicht aus Titan oder Chrom-Nickel (Schichtdicke 0,5...5 nm) und anschliessend mit einer Goldschicht (Schichtdicke: 5...500 nm) bedampft, und zwecks Vermeidung der Oberflächenkräfteabsättigung und Verschmutzung werden die Oberflächen noch in der Vakuumkammer ohne Belüftung miteinander in Berührung gebracht.

Erfindungsgemäss wird die sehr empfindliche Sensormembran beim Verbinden mit ihrem Trägermaterial vor thermischen und mechanischen Verspannungen dadurch geschützt, dass ein dem Ausdehnungskoeffizienten des Silizium-Chips angepasstes Glas als Träger oder sogar ein Siliziumträger gleicher Ausdehnung gewählt und die Verbindung zwischen beiden durch Kaltschweissen in oben beschriebener Weise ausgeführt wird.

Wenn die aufgedampften Schichtdicken die angegebenen Werte nicht wesentlich überschreiten, erfolgt die Verschweissung bei Raumtemperatur ohne notwendigen äusseren Druck. Dadurch werden keinerlei mechanische oder thermische Spannungen in der Messmembran erzeugt. Das für die Vakuumreferenz von Absolutdrucksensoren erforderliche Vakuum in der Vergleichskammer von Totaldrucksensoren wird ohne zusätzlichen Arbeitsgang während des Schweissvorgangs im Vakuum erhalten. Der Kaltschweissvorgang ermöglicht erstmalig die freie Wahl des Trägermaterials aus Glas, Silizium oder anderen Werkstoffen, während das bisher bekannte Verfahren der Aluminiumlegiertechnik auf Silizium und das anodische Verbinden auf ein Glas als Trägerwerkstoff beschränkt war. Diese beiden, bisher bekannten Verfahren waren ausserdem nachteiliger Weise nur bei Temperaturen oberhalb 400 °C ausführbar.

Bei der Erfindung angewendete geringfügige Anpressdrücke von bis zu 10 N/cm² dienen lediglich dazu, die praktisch nicht erreichbare absolute Ebenheit der zu verbindenen Oberflächen durch leichtes Verbiegen der dünnen Scheiben auszugleichen und die beiden Goldschichten aneinanderzulegen. Verbindungen nach dieser Methode sind unlösbar und hermetisch. Bei Zerreissversuchen wurden grundsätzlich nur die verbundenen Werkstoffe selbst zerstört.

Anstatt des Aufdampfens der Metallschichten im Hochvakuum kann auch die Schichterzeugung mittels Katodenzerstäuben angewandt werden. Dieses in den vergangenen Jahren durch Anwendung von Hochfrequenz und Magnetronarbeitsweise verbesserte Verfahren arbeitet ebenfalls im Vakuum und wird häufig zur Erzeugung dünner Schichten angewandt.

Die Vorteile des erfindungsgemässen Verbindungsverfahrens gegenüber den oben beschriebenen bekannten Verfahren sind:

1. Freiheit der Werkstoffwahl. Der Siliziumsensor kann auf einem isolierenden Glasträger auf einem Siliziumträger absolut gleicher Ausdehnung oder auf einem metallischen Träger aufgeschweisst werden.

2. Da die Verbindung bei Raumtemperatur erfolgt, können aufgrund unterschiedlicher Ausdehnungseigenschaften keine mechanischen Spannungen bei der Verbindung entstehen. Die Auswahlkriterien für die thermischen Ausdehnungsunterschiede von Sensor und Träger werden nur noch von der späteren Betriebstemperatur bestimmt.

3. Die benötigten Metallschichten für das Verschweissen können so dünn ausgeführt werden (5. . .500 nm), dass diese bei Temperaturschwankungen keine eigenen Ausdehungskräfte und dadurch bedingte Spannungen erzeugen können. Da weder bei der Schichtaufdampfung noch bei der Verschweissung erhöhte Temperaturen auftreten, besteht keine Gefahr einer Legierung oder Fremddotierung durch Diffusion in die Silizium-Halbleitersensoren.

4. Da das Aufdampfen der Metallschichten sowie ihre Verschweissung im Hochvakuum erfolgt, ergibt sich bei der Herstellung von Absolutdrucksensoren zwangsläufig eine evakuierte Vakuumreferenzkammer. Da als Haftgrund für die Goldauflage eine dünne, zusätzlich als Gettersubstanz wirkende Titanschicht gewählt werden kann, ist das Hochvakuum der Vakuumreferenzkammer auf Dauer garantiert.

5. Dass die Sensorenoberflächen, also auch die für die Montage vorgesehene Rückseite meist mit Siliziumdioxid oder anderen Schutz- und Passivierungsschichten überzogen sind, ist für die erfindungsgemässe Verbindungstechnik kein Nachteil. Während bei den Anodischen- und Legier-Verbindungsverfahren diese Schutzschichten vorher beseitigt werden (Absätzen: DE-OS 2 913 772, Seite 5, zweiter und dritter Absatz) oder durch andere Schichten überlagert werden müssen, können beim Verbindungsverfahren nach der Erfindung die Titan- oder Chrom-Nikkel-Goldschichten direkt aufgedampft und problemlos miteinander verschweisst werden.

6. Kein Lot, Kleber oder andere Adhäsionsmittel erforderlich.

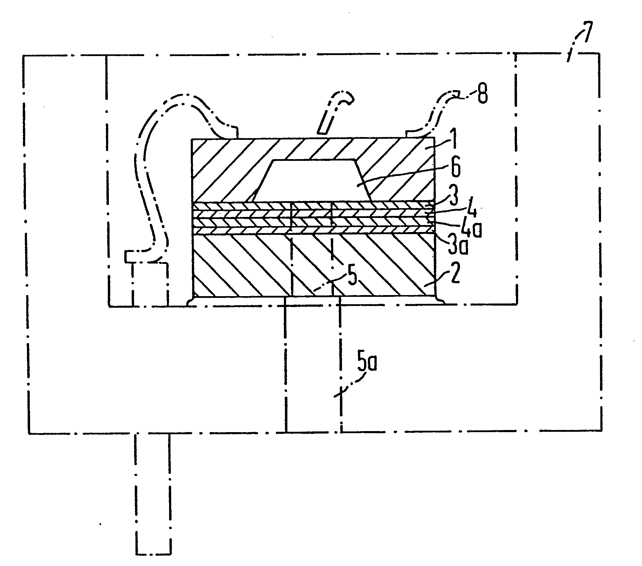

In der Figur ist ein Schnitt durch einen nach der Erfindung kaltgeschweissten Sensor dargestellt. Hierbei bedeuten:

| | |
|---|---|
| 1 | einen Drucksenosr in Silizium-bauweise, |
| 2 | eine Trägerplatte |
| 3 und 3a | eine Haftschicht (Ti; Cr) |
| 4 und 4a | eine Metallschicht (zum Beispiel Au) |
| 5 und 5a | eine Bohrung nur bei Differenzdruck-Sensoren |
| 6 | eine Vakuumreferenzkammer nur bei Absolutdruck-Sensoren, |
| 7 | ein Gehäuse |
| 8 | eine Kontaktierung. |

## Patentansprüche

1. Montage von Halbleiterbauteilen auf einer Trägerplatte, insbesondere von Druckmesswandlern mit einer piezoresistiven Halbleitermembran auf einer die Halbleitermembran mechanisch stabilisierenden Trägerscheibe, dadurch gekennzeichnet, dass die zur verbindenden Oberflächen auf optimale Ebenheit ($< 1\mu$) und optimale Glätte (Ra $< 0,1\,\mu m$) poliert, diese sodann im Hochvakuum mit einer Haftschicht und anschliessend mit einer kaltverschweissenden Metallschicht bedampft und ohne Belüftung noch in der Vakuumkammer miteinander in Berührung gebracht und nahezu drucklos kalt verschweisst werden.

2. Montage nach Anspruch 1, dadurch gekennzeichnet, dass als Haftschicht Titan oder Chrom-Nickel verwendet werden.

3. Montage nach Anspruch 1, dadurch gekennzeichnet, dass als kaltverschweissende Metallschichten zum Beispiel Gold, Silber, Kupfer oder Platin Verwendung finden.

4. Montage nach Anspruch 3, dadurch gekennzeichnet, dass eine Goldschicht von 5. . .500 nm verwendet wird.

5. Montage nach Anspruch 1 bis 4, dadurch gekennzeichnet, dass anstelle der Schichterzeugung durch Aufdampfen im Hochvakuum eine Schichterzugung durch Katodenzerstäubung erfolgt.

6. Montage von Druckmesswandlern nach Anspruch 1, dadurch gekennzeichnet, dass die stabilisierende Trägerscheibe zum Beispiel wie der Druckmesswandler aus Silizium oder einem dem Silizium ausdehnungsmässig angepasstem Glas besteht.

## Revendications

1. Montage de composants à semiconducteurs disposés sur une plaque de support, notamment de capteurs de pression comportant une membrane semiconductrice piézorésistive située sur un disque de support réalisant une stabilisation mécanique de la membrane semiconductrice, caractérisé par le fait qu'on polit les surfaces devant être réunies, de manière à obtenir une planéité optimale ($< 1\,\mu m$) et un poli optimal (Ra $< 0,1\,\mu m$), qu'on dépose alors par évaporation sous vide poussé une couche d'adhérence et ensuite une couche métallique réalisant un soudage à froid sur ces surfaces et qu'on les place en contact l'une àvec l'autre sans aération, dans la chambre à vide, et qu'on les soude à froid presque sans appliquer une pression.

2. Montage suivant la revendication 1, caractérisé par le fait qu'on utilise du titane ou du chromenickel pour constituer la couche d'adhérence.

3. Montage suivant la revendication 1, caractérisé par le fait qu'on utilise par exemple de l'or, de l'argent, du cuivere ou de platine pour constituer des couches métalliques réalisant un soudage à froid.

4. Montage suivant la revendication 3, caractérisé pa le fait qu'un utilise une couche d'or d'une épaisseur de 5. . .500 nm.

5. Montage suivant les revendications 1 à 4, caractérisé par le fait qu'au lieu de former la couche par dépôt par évaporation sous vide poussé, on réalise le dépôt de la couche par pulvérisation cathodique.

6. Montage de capteurs de pression suivant la revendication 1, caractérisé par le fait que le disque de support stabilisateur est constitué par exemple comme le capteur de pression, en silicium ou bien un verre dont la dilatation est adaptée à celle du silicium.

## Claims

1. Mounting of semiconductor components on a carrier plate, in particular of pressure measuring transducers having a piezo-resistive semiconductor diaphragm on a carrier plate which mechanically stabilises the semiconductor diaphragm, characterised in that the surfaces to be connacetd are polished to optimum flatness ($< 1$ μm) and optimum smoothness (Ra $< 0{,}1$ μm), onto which surfaces a bonding layer and then a cold-welding metal layer are vapour deposited in high vacuum and which, without the admission of air, are brought into contact with one another still in the vauum chamber and are cold-welded virtuall without the application of pressure.

2. Mounting as claimed in Claim 1, characterised in that titanium or chromium-nickel is used as bonding layer.

3. Mounting as claimed in Claim 1, characterised in that gold, silver, copper or platinum for example, are used as cold-welding metal layers.

4. Mounting as claimed in Claim 3, characterised in that a gold layer of 5. . .500 nm is used.

5. Mounting as claimed in Claim 1 to 4, characterised in that instead of layer formation by vapour deposition in a high vaccum, the layers are formed by cathode sputtering.

6. Mounting of pressure measuring transducers as claimed in Claim 1, characterised in that the stabilising carrier plate consists, for example, like the pressure measuring transducer, of silicon or a glass which is matched to silicon in respect of its expansion.